# EUROPÄISCHE PATENTANMELDUNG

(11) **EP 4 556 917 A1**
(43) Veröffentlichungstag der Anmeldung: **21.05.2025**
(21) Anmeldenummer: 24187394.2
(22) Anmeldetag: 09.07.2024
(51) Int. Cl.: G01R 31/28, G06F 11/26, G05B 17/02

(54) **SIMULATOR ZUR KONFRONTATION EINES PRÜFLINGS MIT EINEM SIMULIERTEN ELEKTRISCHEN FEHLER**

(30) Priorität: 14.11.2023 DE 102023131699
(71) Anmelder: dSPACE GmbH, 33102 Paderborn (DE)
(72) Erfinder: Sauer, Jochen, 33102 Paderborn (DE); Hasse, Dirk, 33102 Paderborn (DE)

(57) **Zusammenfassung**

Prüfstand (2) zur Konfrontation eines Prüflings (4) mit einem simulierten elektrischen Fehler. Der Prüfstand umfasst eine zentrale Fehlersteuereinheit (10) zur Orchestrierung der simulierten elektrischen Fehler sowie zumindest einen als FIU (Failure Insertion Unit) eingerichteten lokalen Knoten (8a) mit einer Schalteranordnung (16a) zur Verfälschung ausgewählter elektrischer Ströme im Prüfstand. Die Fehlersteuereinheit ist eingerichtet, eine abstrakte Fehlerbeschreibung, die zumindest einen auf eine elektrische Leitung (6a) aufzuschaltenden elektrischen Fehler spezifiziert, zu erstellen und an den lokalen Knoten zu übermitteln. Der lokale Knoten ist eingerichtet, aus der abstrakten Fehlerbeschreibung eine zur Aufschaltung des elektrischen Fehlers auf die elektrische Leitung geeignete Ansteuerungsvorschrift für die Schalteranordnung herzuleiten und durch Ansteuerung der Schalteranordnung gemäß der Ansteuerungsvorschrift den elektrischen Fehler auf die elektrische Leitung aufzuschalten.

## Beschreibung

Die Erfindung betrifft die Simulation elektrischer Fehler für Steuersysteme.

Steuersysteme zur Ansteuerung mechatronischer Systeme, häufig in Form kompakter und geschlossener elektronischer Steuergeräte (ECUs, *Electronic Control Units*) gebaut, werden vor ihrem Serieneinsatz auf korrekte Funktionalität überprüft. Insbesondere für sicherheitskritische Steuersysteme, deren Fehlfunktion im Feld schwerwiegende Folgen nach sich ziehen kann, ist zu diesem Zweck eine Validierung des Steuersystems in einem Prüfstand üblich, der dem Steuersystem eine realitätsnahe virtuelle Arbeitsumgebung bereitstellt, in der das Steuersystem gezielt und reproduzierbar mit unterschiedlichen Situationen konfrontierbar ist, um dessen Reaktion auf diese Situationen zu testen. Derartige Prüfstände sind in der Branche als Hardware-in-the-Loop-Prüfstände, kurz HILs, bekannt.

Zu den durchzuführenden Tests kann es gehören, die Reaktion des Steuersystems auf elektrische Fehler in seiner Arbeitsumgebung zu prüfen. Unter einem elektrischen Fehler kann grundsätzlich jede Abweichung des elektrischen Stromflusses in der Arbeitsumgebung von der vorgesehenen Führung des elektrischen Stromes verstanden werden. Beispiele sind Unterbrechungen durch Kabelbruch, Kurzschlüsse oder Kriechströme durch Kabelverschleiß. Auf dem Markt sind Prüfstände erhältlich, die zu diesem Zweck für die Simulation elektrischer Fehler eingerichtet sind. Typischerweise umfassen derartige Prüfstände spezielle elektrische Leitungen zur Leitung bzw. Übertragung simulierter fehlerhafter Ströme sowie Schalter zur Herstellung bzw. Trennung elektrischer Verbindungen zu den genannten Leitungen.

Im Stand der Technik sind diese Schalter, typischerweise auf modularen Fehlersimulationseinheiten (FIUs, *Failure Insertion Units*) angeordnet, über den Prüfstand verteilt, werden aber von einer zentralen Fehlersteuereinheit des Prüfstands angesteuert. Ein derartiges Design ist gleich in zweifacher Hinsicht nachteilig. Zum einen nimmt die Komplexität des von der Fehlersteuereinheit durchzuführenden Fehlermanagements mit jeder FIU, die dem Prüfstand hinzugefügt wird, zu. Der Prüfstand ist also schlecht skalierbar. Zum anderen muss der Fehlersteuereinheit das Design der FIUs bekannt sein, um die auf ihnen verbauten Schalter korrekt ansteuern zu können. Die Integration spezieller, von einem Standarddesign abweichender FIUs, beispielsweise an einen speziellen Kundenwunsch angepasst und/oder von einem Drittanbieter zugeliefert, ist dadurch schwierig.

Vor diesem Hintergrund besteht die Aufgabe der Erfindung darin, die Ansteuerung lokaler Fehlersimulationseinheiten durch eine zentrale Fehlersteuereinheit zu vereinfachen.

Die die Aufgabe lösende Erfindung ist ein Prüfstand zur Konfrontation eines Prüflings, insbesondere eines Steuersystems, mit einem simulierten elektrischen Fehler. Der Prüfstand umfasst eine zentrale Fehlersteuereinheit zur Orchestrierung der simulierten elektrischen Fehler und zumindest einen ersten lokalen Knoten zur Ausführung einer von der Fehlersteuereinheit veranlassten Fehlersimulation. Der lokale Knoten ist eine FIU, und seine Ausführung der Fehlersimulation geschieht durch Ansteuerung einer ersten Anordnung von Schaltern zur Verfälschung ausgewählter elektrischer Ströme im Prüfstand.

Die Fehlersteuereinheit ist eingerichtet, eine erste abstrakte Fehlerbeschreibung, die zumindest einen ersten elektrischen Fehler zur Aufschaltung auf eine erste elektrische Leitung spezifiziert, zu erstellen und an den ersten lokalen Knoten zu übermitteln. Der erste lokale Knoten ist eingerichtet, aus der ersten abstrakten Fehlerbeschreibung eine erste Ansteuerungsvorschrift, die zur Aufschaltung des ersten elektrischen Fehlers auf die erste elektrische Leitung geeignet ist, für die erste Schalteranordnung herzuleiten und durch Ansteuerung der ersten Schalteranordnung gemäß der ersten Ansteuerungsvorschrift den ersten elektrischen Fehler auf die erste elektrische Leitung aufzuschalten.

Unter einer abstrakten Fehlerbeschreibung ist eine Vorgabe für einen elektrischen Fehler zu verstehen, die zwar einen spezifischen, auf eine konkrete elektrische Leitung aufzuschaltenden elektrischen Fehler vorgibt, aber weder konkrete Schalter aus der ersten oder einer anderen Schalteranordnung benennt, die von einem lokalen Knoten zur Aufschaltung des Fehlers anzusteuern sind, noch Vorgaben enthält, auf welche Weise die Schalter anzusteuern sind. Erfindungsgemäß erhalten die lokalen FIUs also nur eine grundlegende Beschreibung eines auf eine oder mehrere elektrische Leitungen aufzuschaltenden elektrischen Fehlers und sind eingerichtet, aus der grundlegenden Beschreibung eigenständig eine Ansteuerung der Schalter herzuleiten, die den elektrischen Fehler gemäß Beschreibung realisiert.

Die Erfindung verbessert auf diese Weise die Skalierbarkeit des Prüfstands, indem sie die FIUs befähigt, die Aufschaltung simulierter Fehler selbständig zu verwalten. Außerdem erleichtert die Erfindung die Entwicklung neuer FIUs, insbesondere auch als Einzelstücke bzw. Sonderanfertigungen. Eine neu entwickelte FIU muss lediglich ein vorgegebenes, von der zentralen Fehlersteuereinheit verwendetes Protokoll verstehen. Notwendige Anpassungen an der zentralen Fehlersteuereinheit zur Ansteuerung der neu entwickelten FIU sind durch die Erfindung stark reduziert oder, in vorteilhaften Ausgestaltungen der Erfindung, sogar gar nicht mehr nötig.

Im Stand der Technik ist es grundsätzlich bekannt, die Intelligenz zur Ansteuerung von Schaltern von einer zentralen Steuerinstanz an lokale Knoten auszulagern. Beispielhaft beschreibt die Patentanmeldung US 2023 033 3585 A1 ein Hausstromnetz mit dezentralen lokalen Schaltereinheiten, die anhand einer lokal gespeicherten Steuersoftware elektrische Verbraucher an eine Photovoltaikanlage anbinden bzw. von einer Photovoltaikanlage trennen können. Die Ansteuerung der Schalter beruht auf einer Auswertung der von einem Verbraucher umgesetzten Leistung und einer Priorisierung des Verbrauchers, und die Schaltvorgänge beschränken sich auf einfache Verbindungen bzw. Trennungen elektrischer Verbindungen von Verbrauchern zu einer Energiequelle. Eigenständige Herleitungen komplexer Schaltvorgänge zur flexiblen Realisierung unterschiedlicher Stromflüsse sind in der Lehre der genannten Patentanmeldung nicht vorgesehen.

Der erste lokale Knoten ist vorteilhaft als modulares Bauteil ausgestaltet, das dem Prüfstand zerstörungsfrei und auf einfache Weise entnehmbar ist, insbesondere als steckbare Leiterplatte.

Die zentrale Fehlersteuereinheit ist vorteilhaft eingerichtet, zur Orchestrierung der elektrischen Fehler eine auf einem Speichermedium des Prüfstands hinterlegte Verkabelungsbeschreibung auszulesen, in der eine Übersicht über elektrische Leitungen des Prüfstands, inklusive der ersten elektrischen Leitung, und insbesondere auch weitere zur Orchestrierung der elektrischen Fehler benötigte Informationen hinterlegt sind.

Die Fehlersteuereinheit ist vorteilhaft eingerichtet, den ersten elektrischen Fehler in der ersten abstrakten Fehlerbeschreibung als einen Kabelbruch, einen Kurzschluss, einen Kriechstrom auf Masse, einen Kriechstrom zwischen der ersten elektrischen Leitung und einer zweiten elektrischen Leitung, einen Wackelkontakt oder ein Prellmuster (ein unerwünschter elektrischer Kontakt mit zeitlich veränderlichem Widerstand, beispielsweise infolge eines schwingenden Kabelendes oder einer Vibration) zu spezifizieren. Eine Spezifikation eines elektrischen Fehlers ist dabei als eine Anzahl grundlegender Charakteristika einer bestimmten Fehlerart zu verstehen, die die Fehlersteuereinheit dem ersten lokalen Knoten in der ersten abstrakten Fehlerbeschreibung übermittelt. Beispielhaft kann ein "Kriechstrom auf Masse" dadurch spezifiziert sein, dass ein Anteil der über die erste elektrische Leitung geführten Stromstärke von der ersten elektrischen Leitung abgezweigt und auf eine spezielle Leitschiene, die zur Abführung simulierter Kriechströme vorgesehen ist, geführt wird. Der erste lokale Knoten, bzw. eine erfindungsgemäße FIU, würde nach Erhalt dieser Spezifikation selbständig eine Schalterkonfiguration herleiten, die eine über einen elektrischen Widerstand geführte Verbindung von der ersten elektrischen Leitung zu der speziellen Leitschiene herstellt. Natürlich können die grundlegenden Charakteristika in der ersten Fehlerbeschreibung durch konkrete Vorgaben ergänzt sein. Eine konkrete Vorgabe kann beispielsweise eine Stromstärke oder ein elektrischer Widerstand eines Kriechstroms sein. Der erste lokale Knoten, bzw. eine erfindungsgemäße FIU, kann die Vorgabe zum Anlass nehmen, den simulierten Kriechstrom über einen regelbaren Widerstand zu führen und den regelbaren Widerstand so einzustellen, dass die Stromstärke bzw. der elektrische Widerstand des simulierten Kriechstroms der Vorgabe entspricht.

Die erste elektrische Leitung kann grundsätzlich als Energieleitung oder als Datenleitung oder als eine Kombination von beidem (Power over Coax, Power over Ethernet, ...) eingerichtet sein und befindet sich bevorzugt in einer direkten elektrischen Verbindung mit dem Prüfling, sodass die Aufschaltung des ersten elektrischen Fehlers auf die erste elektrische Leitung sich unmittelbar auf den Prüfling auswirkt. Mit anderen Worten ist die erste elektrische Leitung vorteilhaft eingerichtet, einen elektrischen Strom zu leiten, der Energie und/oder Information vom Prüfling zum Prüfstand transferiert oder der Energie und/oder Information in umgekehrter Richtung, vom Prüfstand zum Prüfling, transferiert.

Der Prüfstand umfasst vorteilhaft eine Anordnung von Fehlerleitschienen, d.h. elektrischen Leitungen, die im Prüfstand speziell für die Übertragung elektrischer Ströme zur Simulation elektrischer Fehler verlegt sind, und der erste lokale Knoten ist eingerichtet, durch die Ansteuerung der ersten Schalteranordnung einen elektrischen Kontakt der ersten elektrischen Leitung zu einer Fehlerleitschiene herzustellen. Besonders vorteilhaft umfasst die Anordnung von Fehlerleitschienen parallel verlaufende Fehlerleitschienen, die sich in ihren elektrischen Eigenschaften unterscheiden und für die Simulation unterschiedlicher Arten von elektrischen Fehlern optimiert sind. Insbesondere kann eine Fehlerleitschiene für die Leitung hoher Stromstärken optimiert sein und eine Fehlerleitschiene für die Leitung elektrischer Signale zur Informationsübertragung, d.h. als Datenleitung, optimiert sein.

In einer Ausbaustufe der Erfindung ist der erste lokale Knoten eingerichtet, die erste Fehlerbeschreibung auf Ausführbarkeit zu prüfen und eine festgestellte Nichtausführbarkeit der ersten Fehlerbeschreibung zurückzumelden. Die Rückmeldung kann an die zentrale Fehlersteuereinheit oder an eine andere Instanz des Prüfstands erfolgen, z.B. an eine graphische Nutzerschnittstelle (GUI, Graphical User Interface) einer Bedienkomponente des Prüfstands. Die Prüfung auf Ausführbarkeit umfasst dabei eine Prüfung, ob technische Komponenten des ersten lokalen Knotens, insbesondere Schalter aus der ersten Schalteranordnung, die für eine Aufschaltung des ersten elektrischen Fehlers gemäß der ersten Fehlerbeschreibung notwendigen Spezifikationen erfüllen. Die Prüfung kann einen Vergleich einer Zeitvorgabe in der ersten Fehlerbeschreibung mit einer Schaltzeit zumindest eines Schalters aus der ersten Schalteranordnung umfassen, um zu prüfen, ob die Zeitvorgabe erfüllbar ist. Die Prüfung kann einen Vergleich einer Stromfestigkeit, insbesondere zumindest eines Schalters aus der ersten Schalteranordnung, mit einer in der ersten Fehlerbeschreibung enthaltenen Stromstärkenvorgabe umfassen, um eine Beschädigung von Komponenten des ersten lokalen Knotens zu vermeiden. Die Prüfung kann einen Vergleich einer Durchschlagspannung, insbesondere zumindest eines Schalters aus der ersten Schalteranordnung, mit einer in der ersten Fehlerbeschreibung enthaltenen Spannungsvorgabe umfassen. Die Prüfung kann eine Prüfung auf Kompatibilität der ersten Ansteuerungsvorschrift mit einer anderen, bereits auf dem ersten lokalen Knoten hinterlegten Ansteuerungsvorschrift umfassen, wobei keine Kompatibilität insbesondere dann vorliegt, wenn der erste elektrische Fehler und der von der anderen Ansteuerungsvorschrift geschaltete elektrische Fehler nicht gleichzeitig ausführbar sind, beispielsweise wegen einer Doppelbelegung eines Schalters.

Die FIUs des Prüfstands umfassen in ihrer Gesamtheit vorteilhaft mechanische Schalter und Halbleiterschalter. Mechanische Schalter weisen im Allgemeinen eine höhere Stromfestigkeit und im geöffneten Zustand eine bessere Isolierungswirkung auf. Sie sind dadurch besonders geeignet für die Übertragung hoher Stromstärken oder für die Simulation eines Kabelbruchs bei hoher Spannung. Halbleiterschalter sind regelbar und weisen kürzere Schaltzeiten auf. Dadurch sind sie besonders geeignet für die Simulation von Kriechströmen, von Prellmustern und für schnelle Schaltvorgänge. Besonders vorteilhaft umfassen die einzelnen FIUs, wie der erste lokale Knoten, sowohl Halbleiterschalter als auch mechanische Schalter, um jeweils lokal viele unterschiedliche Arten von elektrischen Fehlern simulieren zu können.

Der erste lokale Knoten ist vorteilhaft eingerichtet, eine zur Aufschaltung des ersten elektrischen Fehlers benötigte erste Zeitspanne zu ermitteln und der Fehlersteuereinheit zu übermitteln, damit die Fehlersteuereinheit die erste Zeitspanne bei der Orchestrierung der simulierten elektrischen Fehler berücksichtigen kann. Die Ermittlung der ersten Zeitspanne kann insbesondere auf Basis von Schaltzeiten von Schaltern erfolgen, die in der ersten Ansteuerungsvorschrift adressiert sind.

Besonders vorteilhaft ist die Fehlersteuereinheit eingerichtet, unter Nutzung der ersten Zeitspanne die Aufschaltung des ersten elektrischen Fehlers mit der Aufschaltung zumindest eines zweiten elektrischen Fehlers durch einen zweiten lokalen Knoten zu synchronisieren. Dabei können der erste und der zweite elektrische Fehler rein zeitlich korreliert und ansonsten voneinander unabhängig sein. Ebenso ist es aber möglich, dass die Synchronisierung des ersten und des zweiten elektrischen Fehlers zum Zweck der Aufschaltung eines elektrischen Makrofehlers erfolgt, zu dessen Aufschaltung sowohl der erste lokale Knoten als auch der zweite lokale Knoten, möglicherweise auch noch weitere lokale Knoten, erforderlich sind. Beispielhaft kann der elektrische Makrofehler ein Kriechstrom von der ersten elektrischen Leitung zu einer zweiten elektrischen Leitung sein, für dessen Simulation es erforderlich ist, mittels des ersten lokalen Knotens die erste elektrische Leitung an eine Fehlerleitschiene anzubinden und mittels des zweiten elektrischen Knotens dieselbe Fehlerleitschiene an die zweite elektrische Leitung anzubinden.

Die Fehlersteuereinheit ist in dieser Ausprägung der Erfindung eingerichtet, eine zweite abstrakte Fehlerbeschreibung, die zumindest eine zweite elektrische Leitung und einen auf die zweite elektrische Leitung aufzuschaltenden zweiten elektrischen Fehler spezifiziert, zu erstellen und an den zweiten lokalen Knoten zu übermitteln. Der zweite lokale Knoten umfasst eine zweite Schalteranordnung und ist eingerichtet, aus der zweiten abstrakten Fehlerbeschreibung eine zur Aufschaltung des zweiten elektrischen Fehlers auf die zweite elektrische Leitung geeignete zweite Ansteuerungsvorschrift für die zweite Schalteranordnung herzuleiten, eine zur Aufschaltung des zweiten elektrischen Fehlers benötigte zweite Zeitspanne zu ermitteln und die zweite Zeitspanne der Fehlersteuereinheit zu übermitteln, und durch Ansteuerung der zweiten Schalteranordnung gemäß der zweiten Ansteuerungsvorschrift den zweiten elektrischen Fehler auf die zweite elektrische Leitung aufzuschalten. Die Fehlersteuereinheit ist eingerichtet, die Aufschaltung des ersten elektrischen Fehlers unter Berücksichtigung der ersten Zeitspanne und der zweiten Zeitspanne mit der Aufschaltung des zweiten elektrischen Fehlers zu synchronisieren.

Je nach Ausgestaltung der Erfindung kann die zweite abstrakte Fehlerbeschreibung sich von der ersten abstrakten Fehlerbeschreibung unterscheiden oder zu dieser identisch sein. In einer möglichen Ausgestaltung der Erfindung erstellt die Fehlersteuereinheit für jeden lokalen Knoten eine individuelle Fehlerbeschreibung. In dieser Ausgestaltung verbleibt aber ein Teil der Fehlerplanung bei der Fehlersteuereinheit, die zumindest herleiten muss, welche lokalen Knoten auf welche Weise an der Aufschaltung eines gegebenen Fehlers beteiligt sind. Vorteilhaft ist die Fehlerplanung vollständig auf die lokalen Knoten ausgelagert.

Dazu kann die Fehlersteuereinheit ausgestaltet sein, eine Fehlerbeschreibung zur Beschreibung eines Fehlers in Form eines Broadcasts an alle in dem Prüfstand verbauten lokalen Knoten zu verschicken, und zwar unabhängig davon, ob an dem Fehler nur ein lokaler Knoten beteiligt ist oder ob es sich um einen Makrofehler handelt, an dessen Aufschaltung zwei oder mehr lokale Knoten beteiligt sind. In dieser Ausgestaltung erhalten also der erste lokale Knoten, der zweite lokale Knoten sowie jeder weitere in dem Prüfstand verbaute lokale Knoten eine Kopie derselben Fehlerbeschreibung. Jeder lokale Knoten, insbesondere der erste lokale Knoten und der zweite lokale Knoten, ist ausgestaltet, die Fehlerbeschreibung zu analysieren und anhand der Analyse zu erkennen, ob er selbst an der Aufschaltung des Fehlers beteiligt ist, und die Fehlerbeschreibung, sollte das nicht der Fall sein, zu ignorieren.

Zur Aufschaltung eines Makrofehlers erfordert diese Ausgestaltung natürlich eine gewisse Absprache zwischen den an der Aufschaltung des Makrofehlers beteiligten lokalen Knoten. Ist beispielsweise, um das eben beschriebene Beispiel eines Kriechstroms zwischen der ersten und der zweiten elektrischen Leitung wieder aufzugreifen, in der dazugehörigen Fehlerbeschreibung ein Widerstand des Kriechstroms spezifiziert, dann muss durch eine Konvention festgelegt sein, welchen Beitrag zur Aufschaltung des Widerstands der erste lokale Knoten und der zweite lokale Knoten jeweils leisten.

Dafür sind unterschiedliche Lösungen denkbar. Beispielsweise können beide lokalen Knoten ausgestaltet sein, in so einem Fall jeweils die Hälfte des spezifizierten Widerstands aufzuschalten. Alternativ kann anhand einer vordefinierten Hierarchie der lokalen Knoten festgelegt sein, welcher lokale Knoten für die Aufschaltung des Widerstands verantwortlich ist. Wiederum alternativ können der erste und der zweite lokale Knoten ausgestaltet sein, untereinander Nachrichten auszutauschen, um festzulegen, ob der erste oder der zweite lokale Knoten für die Aufschaltung des Widerstands verantwortlich ist. Eine weitere Möglichkeit ist, derartige unklare Aufgabenverteilungen durch eine eindeutige Systemarchitektur von vornherein zu vermeiden. In dem genannten Beispiel kann das zum Beispiel bedeuten, dass nur der erste der lokale Knoten überhaupt zur Aufschaltung von Widerständen auf die Fehlerleitschiene ausgestaltet ist und der zweite lokale Knoten ausgestaltet ist, entsprechende Spezifikationen von Widerständen zu ignorieren, oder dass zur Regelung des elektrischen Widerstands der Fehlerleitschiene ein dediziert dafür vorgesehener dritter lokaler Knoten auf der Fehlerleitschiene angeordnet ist.

Die nachfolgenden Beschreibungen der Zeichnungen skizzieren ein Ausführungsbeispiel der Erfindung. Es zeigen
- Figur 1: eine schematische Darstellung eines erfindungsgemäßen Prüfstands mit einem ersten lokalen Knoten und einem zweiten lokalen Knoten zur Fehlersimulation;
- Figur 2: ein Ablaufdiagramm einer mit dem Prüfstand durchgeführten Simulation eines elektrischen Fehlers aus Sicht der zentralen Fehlersteuereinheit;
- Figur 3: ein Ablaufdiagramm derselben Simulation aus Sicht eines lokalen Knotens;
- Figur 4: ein erstes Schaltbeispiel zur Simulation eines elektrischen Fehlers;
- Figur 5: ein zweites Schaltbeispiel zur Simulation eines elektrischen Fehlers; und
- Figur 6: ein drittes Schaltbeispiel zur Simulation eines elektrischen Fehlers.

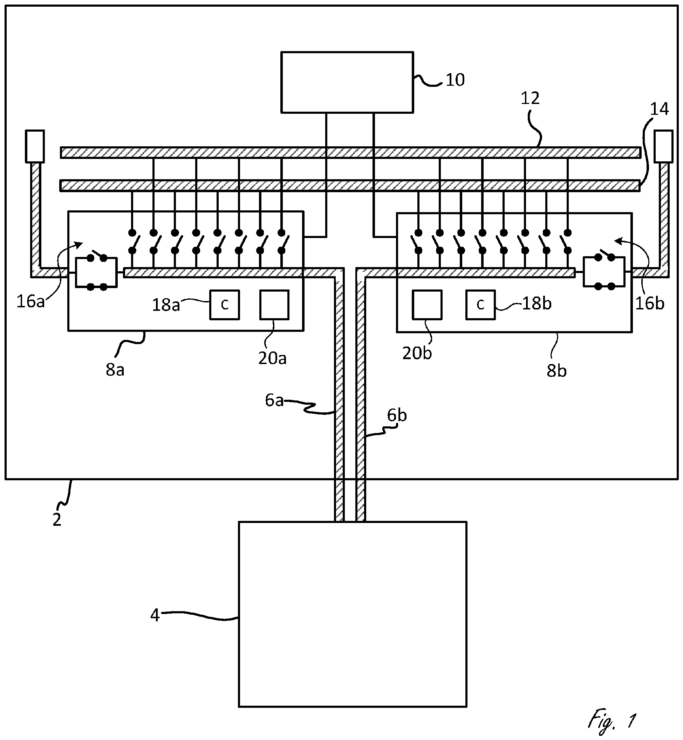

Die Abbildung der Figur 1 zeigt einen Prüfstand 2, der beispielhaft über zwei elektrische Leitungen 6, eine erste elektrische Leitung 6a und eine zweite elektrische Leitung 6b, mit einem Prüfling verbunden ist. Die erste elektrische Leitung 6a und die zweite elektrische Leitung 6b repräsentieren elektrische Leitungen, mittels derer der Prüfling 4 in einem Normalbetrieb in eine Arbeitsumgebung eingebunden wäre, um elektrische Energie und/oder Daten mit der Arbeitsumgebung auszutauschen. Der Prüfstand 2 ist eingerichtet, den Stromfluss auf den elektrischen Leitungen 6 derart anzusteuern, dass dem Prüfling 4 glaubhaft und realitätsnah ein Normalbetrieb in der Arbeitsumgebung vorgetäuscht wird. Dafür umfasst der Prüfstand 2 einen zentralen Prozessor, der auch als zentrale Fehlersteuereinheit 10 eingerichtet ist und außerdem ein Simulationsmodell abarbeitet und auf Basis des Simulationsmodells synthetische Sensordaten erzeugt und dem Prüfling 4 zuführt, Steuerdaten vom Prüfling 4 einliest und im Simulationsmodell berücksichtigt, elektrische Ströme auf den elektrischen Leitungen 6 induziert, oder auf vom Prüfling induzierte Ströme auf den elektrischen Leitungen 6 reagiert. Der Prüfstand 2 stellt dem Prüfling auf diese Weise eine virtuelle Arbeitsumgebung bereit, innerhalb dessen der Prüfling gefahrlos und reproduzierbar auf korrekte Funktion prüfbar ist. Der Prüfling 4 kann insbesondere ein elektronisches Steuergerät sein, beispielsweise zur Ansteuerung eines Motors, einer Batterie, eines Wechselrichters oder einer beliebigen elektrischen Anlage.

In seiner Funktion als zentrale Fehlersteuereinheit 10 ist der zentrale Prozessor eingerichtet, mittels dafür eingerichteter lokaler Knoten 8 elektrische Fehler auf die elektrischen Leitungen 6 aufzuschalten, um eine wunschgemäße Reaktion des Prüflings 4 darauf zu prüfen. Dazu umfasst der Prüfstand 2 einen ersten lokalen Knoten 8a und einen zweiten lokalen Knoten 8b. Beide lokalen Knoten 8 sind als modulare, austauschbare FIUs eingerichtet. Der Prüfstand 2 umfasst außerdem eine Anordnung von Fehlerleitschienen, in der Zeichnung repräsentiert durch eine erste Fehlerleitschiene 12 und eine parallel zur ersten Fehlerleitschiene 12 verlaufende zweite Fehlerleitschiene 14. Die Anordnung von Fehlerleitschienen ist busartig in dem Prüfstand 2 angeordnet, sodass durch Verschaltung von Fehlerleitschienen untereinander und/oder mit an unterschiedlichen Orten im Prüfstand 2 angeordneten FIUs 8 jede FIU 8 des Prüfstands 2 mit der Anordnung von Fehlerleitschienen verschaltbar ist und auf diese Weise eine Vielzahl von Strompfaden zur Simulation elektrischer Fehler realisierbar ist. Die parallel verlaufenden Fehlerleitschienen können sich hinsichtlich ihrer elektrischen Eigenschaften unterscheiden. Beispielhaft ist die erste Fehlerleitschiene 12 für die Leitung hoher Stromstärken und die zweite Fehlerleitschiene 14 für die Übertragung von Signalen optimiert.

Der erste lokale Knoten 8a umfasst eine erste Schalteranordnung 16a, anhand derer ein elektrischer Kontakt zwischen der ersten elektrischen Leitung 6a und der ersten Fehlerleitschiene 12 oder der zweiten Fehlerleitschiene 14 herstellbar ist. Die erste Schalteranordnung 16a umfasst außerdem Schalter zur Unterbrechung der ersten elektrischen Leitung 6a und zur Erhöhung des elektrischen Widerstands der ersten elektrischen Leitung 6a. Die erste Schalteranordnung 16a umfasst eine Vielzahl von Schaltern mit unterschiedlichen technischen Spezifikationen und Kennzahlen. Insbesondere umfasst die erste Schalteranordnung sowohl mechanische Schalter, die für die Leitung hoher Stromstärken ausgelegt sind, als auch Halbleiterschalter, die schnell und zeitpräzise schaltbar und regelbar sind.

Die Darstellung der ersten Schalteranordnung 16a ist stark vereinfacht. Eine marktübliche FIU umfasst zur Aufschaltung eines elektrischen Fehlers ein komplexes Netzwerk von Schaltern, deren Ansteuerung weit weniger trivial ist, als es in der Abbildung erscheint.

Der erste lokale Knoten 8a umfasst einen ersten lokalen Speicher 20a und eine erste lokale Prozessoreinheit 18a zur Ansteuerung der einzelnen Schalter in der ersten Schalteranordnung 16a. Auf dem ersten lokalen Speicher 20a sind alle Informationen, die die erste lokale Prozessoreinheit 18a zur erfindungsgemäßen Ansteuerung der ersten Schalteranordnung 16a benötigt, entweder nativ hinterlegt oder werden wie nachfolgend beschrieben von der Fehlersteuereinheit 10 hinterlegt. Zu den nativ hinterlegten Informationen gehört zumindest eine Auflistung der Schalter in der ersten Schalteranordnung 16a sowie von Kenngrößen der einzelnen aufgelisteten Schalter. Mögliche Beispiele für Kenngrößen sind Begrenzungen der übertragbaren Stromstärke, Schaltzeiten, Regelgüten (z.B. Anregelzeiten, Überschwingweiten, Ausregelzeiten), Regelgenauigkeiten und Durchschlagsspannungen. Die erste lokale Prozessoreinheit 18a ist eingerichtet, die auf dem ersten lokalen Speicher 20a hinterlegten Informationen auszulesen und zu verwerten.

Der zweite lokale Knoten 8b ist in seiner grundlegenden Funktionalität auf gleiche Weise eingerichtet wie der erste lokale Knoten 8a und ist auf analoge Weise angeordnet, einen elektrischen Fehler auf die zweite elektrische Leitung 6b aufzuschalten. Er umfasst eine zweite Schalteranordnung 16b, eine zweite lokale Prozessoreinheit 18b und einen zweiten lokalen Speicher 20b, die analog zu ihren funktionalen Gegenstücken auf dem ersten lokalen Knoten 8a eingerichtet und untereinander verschaltet sind. Die zweite Schalteranordnung 16b kann sich im Detail von der ersten Schalteranordnung 16a unterscheiden, insbesondere hinsichtlich der Anzahl von Schaltern, der technischen Spezifikationen und Kennzahlen der einzelnen Schalter sowie der Schaltungstopologie.

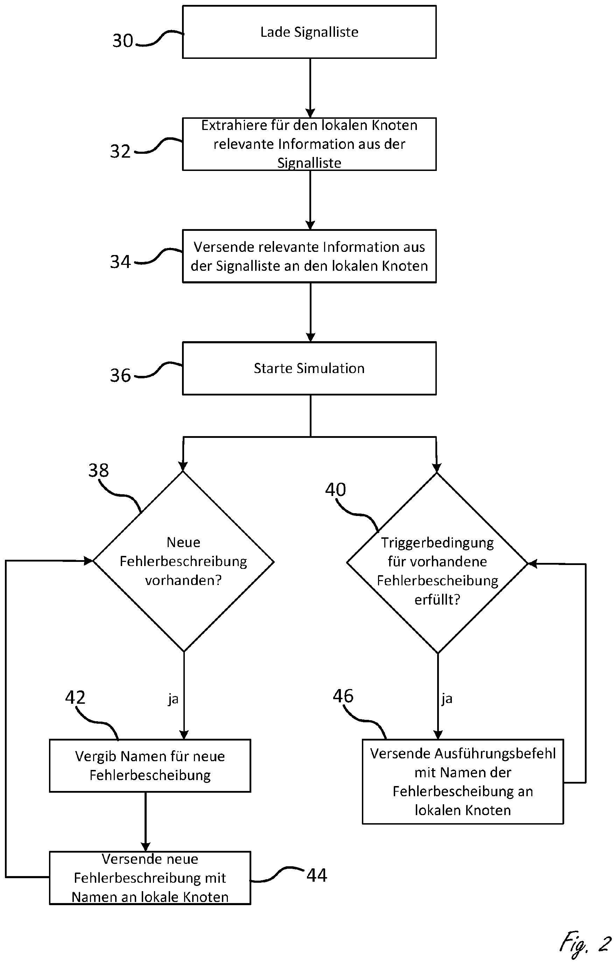

Die Abbildung der Figur 2 skizziert in Form eines Ablaufdiagramms einen beispielhaften von dem Prüfstand 2 durchgeführten Simulationsdurchlauf aus Sicht der zentralen Fehlersteuereinheit 10. Der Simulationsdurchlauf umfasst Simulationen elektrischer Fehler, die die Fehlersteuereinheit 10 im Zusammenspiel mit zumindest einem lokalen Knoten 8 orchestriert. Der besagte lokale Knoten kann der erste lokale Knoten 8a, der zweite lokale Knoten 8b oder auch ein beliebiger weiterer lokaler Knoten (nicht dargestellt) sein. Wenn die Fehlersteuereinheit 10 bei der Orchestrierung der elektrischen Fehler von mehr als einem lokalen Knoten 8 Gebrauch macht, dann wird der in der Figur 2 dargestellte Ablauf für jeden der in dem Simulationsdurchlauf in Gebrauch kommenden lokalen Knoten 8 parallel durchgeführt.

In einem ersten Schritt 30wird eine Signalliste auf die Fehlersteuereinheit 10 geladen und von dieser ausgewertet. Die Signalliste ist eine Verkabelungsbeschreibung, in der die erste elektrische Leitung 6a, die zweite elektrische Leitung 6b und eine Vielzahl weiterer elektrischer Leitungen des Prüfstands 2 aufgeführt sind. Die Signalliste umfasst im Allgemeinen die für die durchzuführende Simulation spezifisch relevanten elektrischen Leitungen und Komponenten des Prüfstands 2 und beschreibt deren elektrische Verbindungen untereinander. Die Signalliste spezifiziert außerdem die im Rahmen der Simulation auf den besagten elektrischen Leitungen zu übertragenden Ströme bzw. Signale und deren Führung über die elektrischen Leitungen.

In einem zweiten Schritt 32 extrahiert die Fehlersteuereinheit 10 aus der Signalliste die für den lokalen Knoten 8 relevante Information. Diese relevante Information umfasst insbesondere die elektrischen Leitungen 6 sowie die Fehlerleitschienen 12, 14, deren Stromfluss der lokale Knoten 8 mittels seiner Schalteranordnung 16 beeinflussen kann. Die relevante Information kann weiterhin (optionale oder obligatorische) Informationen umfassen, anhand derer der lokale Knoten 8 die Ausführbarkeit eines aufzuschaltenden Fehlers überprüfen kann, insbesondere Kennzahlen der Fehlerleitschienen 12, 14, z.B. maximal übertragbare Stromstärken, sowie der auf den elektrischen Leitungen 6 zu erwartenden Ströme, z.B. maximale Stromstärken und maximale Spannungen. Die für den ersten lokalen Knoten 8a relevante Information würde also beispielsweise eine Beschreibung der ersten elektrischen Leitung 6a, der ersten Fehlerleitschiene 12 und der zweiten Fehlerleitschiene 14 enthalten. Die für einen lokalen Knoten 8 aus der Signalliste extrahierte Information umfasst die gesamte Information, die der lokale Knoten 8 zur Aufschaltung eines noch zu definierenden Fehlers auf eine elektrische Leitung 6 benötigt. Die Fehlersteuereinheit 10 versendet anschließend in einem dritten Schritt 34 die extrahierte Information an den lokalen Knoten 8, und der lokale Knoten 8 speichert die extrahierte Information in seinem lokalen Speicher 20.

Der erste Schritt 30, der zweite Schritt 32 und der dritte Schritt 34 sind jeweils Teil einer initialen Konfigurationsphase des Prüfstands 2. Nach Abschluss der Konfigurationsphase startet die Fehlersteuereinheit 10 in einem vierten Schritt 36 die Simulation.

Während der laufenden Simulation können mittels einer Bedienkomponente des Prüfstands 2 Fehlerbeschreibungen in einem von der zentralen Fehlersteuereinheit 10 auslesbaren Speicher hinterlegt werden. Die Bedienkomponente kann beispielsweise ein im Prüfstand 2 verbautes Terminal sein oder ein mit dem Prüfstand 2 verbundener Personal Computer (PC), auf dem eine Bediensoftware installiert ist. Zur Hinterlegung einer Fehlerbeschreibung erstellt zunächst ein Anwender ein Fehlerszenario. Das Fehlerszenario beschreibt einen zu simulierenden elektrischen Fehler in einem hohen Abstraktionsgrad und im Zusammenhang einer von dem Prüfstand 2 simulierten virtuellen Arbeitsumgebung des Prüflings 4. Beispielhaft kann der Prüfling 4 ein Motorsteuergerät sein, und der Prüfstand 2 stellt dem Prüfling 4 als virtuelle Arbeitsumgebung ein virtuelles, von dem Prüfling 4 ansteuerbares Motorfahrzeug bereit. Das Fehlerszenario kann in diesem Zusammenhang den zu simulierenden elektrischen Fehler beispielsweise als einen Kabelbruch einer bestimmten elektrischen Leitung zu einer bestimmten Zündkerze des virtuellen Fahrzeugs beschreiben, wobei besagte Zündkerze ausschließlich als virtuelle Komponente in die Simulation eingebunden ist, ohne als physische Komponente in dem Prüfstand 2 verbaut zu sein.

Zu einer Fehlerbeschreibung gehört neben der Beschreibung des Fehlers auch zumindest eine Triggerbedingung für die Aufschaltung des jeweiligen Fehlers während der Simulation. Eine Triggerbedingung legt ein Anwender im Zuge der Hinterlegung eines Fehlerszenarios fest. Eine Triggerbedingung muss von der zentralen Fehlersteuereinheit 10 überprüfbar sein, kann davon abgesehen aber grundsätzlich beliebig ausgestaltet sein. Eine Triggerbedingung kann beispielsweise ein simuliertes Ereignis in der Simulation sein, der Ablauf einer vordefinierten Zeitspanne oder eine Auslösung eines manuellen Triggers mittels der Bedienkomponente.

Die zentrale Fehlersteuereinheit 10 übersetzt das Fehlerszenario automatisch in eine abstrakte Fehlerbeschreibung und hinterlegt die neue Fehlerbeschreibung in dem dafür vorgesehenen Speicher. Anders als das Fehlerszenario nimmt die abstrakte Fehlerbeschreibung auf konkrete, physisch vorhandene elektrische Leitungen 6 des Prüfstands 2 Bezug. Zur Übersetzung eines Fehlerszenarios in eine abstrakte Fehlerbeschreibung greift die zentrale Fehlersteuereinheit 10 auf die Signalliste und auf Informationen aus der virtuellen Arbeitsumgebung zu. In dem vorgenannten Beispiel mit der Zündkerze kann beispielsweise in einer Einrichtungsphase des Prüfstands 2 festgelegt worden sein, dass die erste elektrische Leitung 6a die elektrische Leitung zu der Zündkerze simuliert. Gemäß der in dem Fehlerszenario hinterlegten Anforderung, einen Kabelbruch der elektrischen Leitung zu simulieren, wäre in der daraus hergeleiteten Fehlerbeschreibung eine physische Unterbrechung der ersten elektrischen Leitung 6a beschrieben.

Zur Laufzeit der Simulation überprüft die zentrale Fehlersteuereinheit 10 in einem fünften Schritt 38, ob eine neue Fehlerbeschreibung vorhanden ist, wobei eine Fehlerbeschreibung als neu gilt, wenn sie noch nicht an mindestens einen lokalen Knoten versendet wurde (siebter Schritt 44). Wenn das der Fall ist, vergibt die zentrale Fehlersteuereinheit 2 in einem sechsten Schritt 42 einen Namen für die neue Fehlerbeschreibung. Der Name ist eine beliebig ausgestaltete Kennung, anhand derer die neue Fehlerbeschreibung im weiteren Verlauf der Simulation eindeutig identifizierbar ist.

In einem siebten Schritt 44 erstellt die Fehlersteuereinheit 10 eine Nachricht, in der die neue Fehlerbeschreibung und deren Namen enthalten sind, und verschickt die Nachricht als Broadcast über den Bus des Prüfstands 2, sodass jeder lokale Knoten 8 eine Kopie der Nachricht empfängt. Auf diese Weise übermittelt die Fehlersteuereinheit 10 in Form der Nachricht eine erste Fehlerbeschreibung an den ersten lokalen Knoten 8a und eine zur ersten Fehlerbeschreibung identische zweite Fehlerbeschreibung an den zweiten lokalen Knoten 8b.

Parallel zum fünften Schritt 38 überprüft die Fehlersteuereinheit 10 zur Laufzeit der Simulation in einem achten Schritt 40, ob eine Triggerbedingung für eine der vorhandenen (d.h. nicht neuen) Fehlerbeschreibungen erfüllt ist. Sobald eine Triggerbedingung für eine Fehlerbeschreibung erfüllt ist, liest die Fehlersteuereinheit 10 den Namen der Fehlerbeschreibung, deren Triggerbedingung erfüllt ist, aus und versendet in einem neunten Schritt 46 einen Ausführungsbefehl, der auch den Namen der auszuführenden Fehlerbeschreibung umfasst, als Broadcast über den Bus des Prüfstands an alle lokalen Knoten, sodass sowohl der erste lokale Knoten 8a als auch der zweite lokale Knoten 8b den Ausführungsbefehl empfängt.

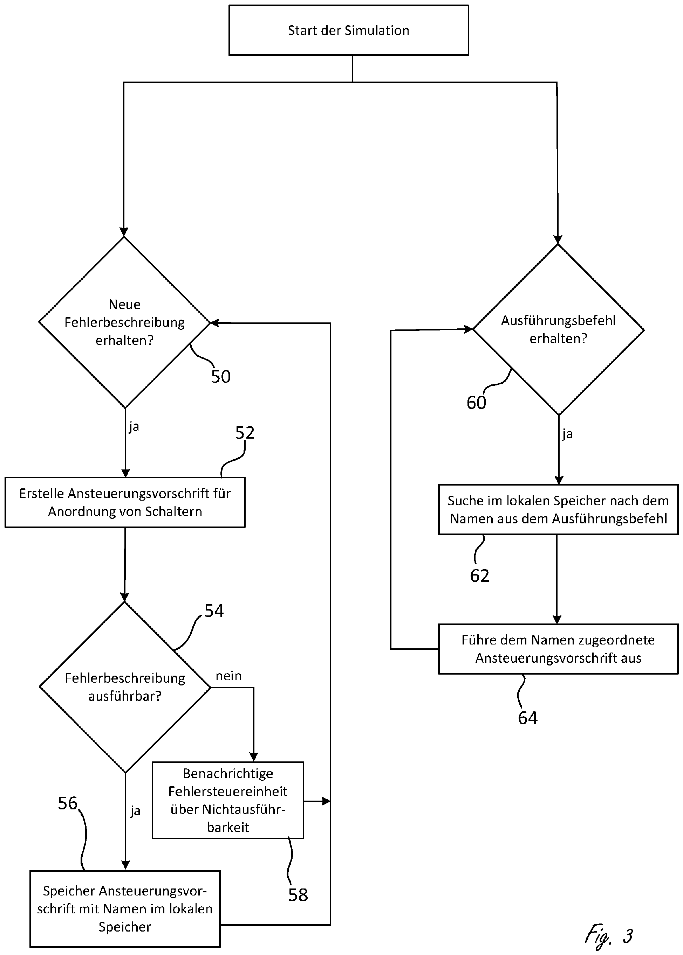

Das Ablaufdiagramm in der Figur 3 skizziert die von einem lokalen Knoten 8 zur Laufzeit der Simulation durchgeführten Schritte. Der Prüfstand 2 ist eingerichtet, jede im Schritt 42 versandte neue Fehlerbeschreibung im lokalen Speicher 20 des jeweiligen die neue Fehlerbeschreibung empfangenden lokalen Knotens 8 zu hinterlegen. Der lokale Knoten 8 führt in einem zehnten Schritt 50 eine zyklische Prüfung durch, ob im lokalen Speicher 20 eine neue Fehlerbeschreibung hinterlegt ist, wobei eine Fehlerbeschreibung als neu gilt, wenn für die Fehlerbeschreibung noch kein Prozess zur Erstellung einer Ansteuerungsvorschrift (elfter Schritt 52) gestartet wurde.

Wenn das der Fall ist, startet der lokale Knoten in einem elften Schritt 52 eine auf der lokalen Prozessoreinheit 18 hinterlegte Routine zur Erstellung einer Ansteuerungsvorschrift für seine Schalteranordnung 16. Die Routine wertet die in der Fehlerbeschreibung hinterlegten Anforderungen aus und überprüft zunächst, ob der jeweilige lokale Knoten 8 an der Aufschaltung des in der Fehlerbeschreibung beschriebenen elektrischen Fehlers überhaupt beteiligt ist. Wenn das nicht der Fall ist, ignoriert der lokale Knoten 8 die Fehlerbeschreibung, d.h. er stellt die Bearbeitung der Fehlerbeschreibung ein und löscht sie aus seinem lokalen Speicher 8. Im Normalfall ist ein lokaler Knoten an der Aufschaltung eines Fehlers beteiligt, wenn dessen Fehlerbeschreibung eine elektrische Leitung 8 des Prüfstands 2 umfasst, mit der der jeweilige lokale Knoten 8 verschaltet ist. Würde beispielsweise der erste lokale Knoten 8a im ersten lokalen Speicher 20a eine Fehlerbeschreibung vorfinden, die einen auf die zweite elektrische Leitung 8b aufzuschaltenden Fehler beschreibt, dann würde der erste lokale Knoten diese Fehlerbeschreibung ignorieren, weil kein Schalter aus der ersten Anordnung von Schaltern 16a mit der zweiten elektrischen Leitung 6b verschaltet ist.

Kommt der lokale Knoten 8 bei der Überprüfung zu dem Schluss, dass er an der Aufschaltung des Fehlers beteiligt ist, erstellt der lokale Knoten 8 unter Berücksichtigung der Informationen, die auf seinem eigenen lokalen Speicher 20 hinterlegt sind, eine Ansteuerungsvorschrift für seine eigene Schalteranordnung 16 zur Aufschaltung des in der Fehlerbeschreibung spezifizierten Fehlers auf die in der Fehlerbeschreibung spezifizierte elektrische Leitung 6.

In einem zwölften Schritt 54 prüft der lokale Knoten 8, ob die Fehlerbeschreibung ausführbar ist, wobei der lokale Knoten 8 die Fehlerbeschreibung genau dann als ausführbar wertet, wenn im elften Schritt 52 erfolgreich eine die Vorgaben der Fehlerbeschreibung erfüllende Ansteuerungsvorschrift hergeleitet wurde. Wenn die Ansteuerungsvorschrift vorliegt, speichert der lokale Knoten 8 in einem dreizehnten Schritt 56 die Ansteuerungsvorschrift zusammen mit dem in der Fehlerbeschreibung hinterlegten Namen im lokalen Speicher 20. Liegt keine Ansteuerungsvorschrift vor, weil die auf der lokalen Prozessoreinheit 18 hinterlegte Routine die Vorgaben der Fehlerbeschreibung als nicht erfüllbar bewertete, erstellt in einem vierzehnten Schritt 58 der lokale Knoten 8 eine Nachricht über die Nichtausführbarkeit der Fehlerbeschreibung und versendet die Nachricht an die zentrale Fehlersteuereinheit 10.

Parallel zur Prüfung auf neue Fehlerbeschreibungen (zehnter Schritt 50) führt der lokale Knoten 8 in einem fünfzehnten Schritt 60 eine zyklische Prüfung durch, ob ein neuer Ausführungsbefehl von der Fehlersteuereinheit 10 vorliegt. Wenn ein neuer Ausführungsbefehl vorliegt, liest der lokale Knoten 8 den in dem neuen Ausführungsbefehl hinterlegten Namen aus, sucht in seinem lokalen Speicher 20 nach dem Namen und, sofern er dort eine dem Namen zugeordnete Ansteuerungsvorschrift vorfindet, führt die dem Namen zugeordnete Ansteuerungsvorschrift aus, um den mit dem Namen assoziierten elektrischen Fehler auf die elektrische Leitung 6 aufzuschalten. Wenn der lokale Knoten 8 keine dem Namen zugeordnete Ansteuerungsvorschrift vorfindet, ignoriert der lokale Knoten 8 den Ausführungsbefehl.

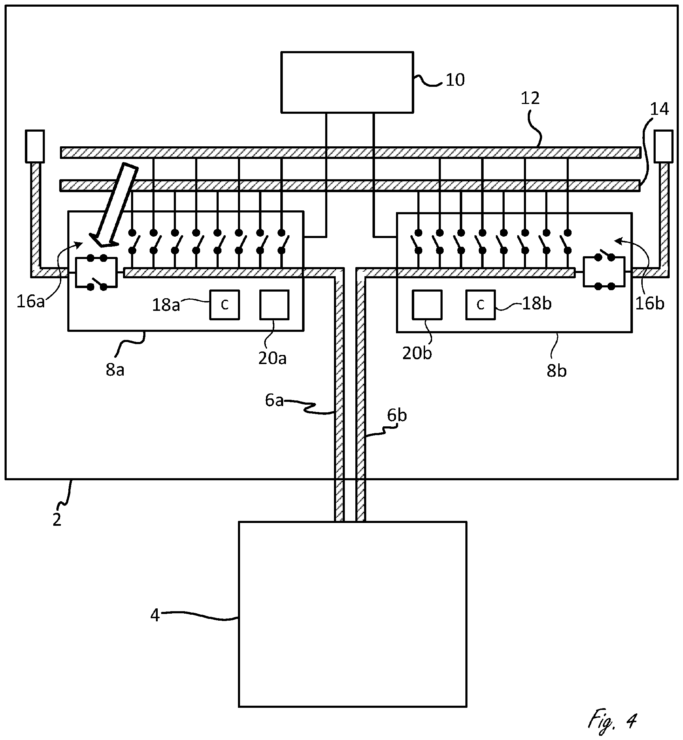

Die Abbildungen der Figuren 4 bis 6 zeigen den Prüfstand 2 mit beispielhaft geänderten Schalterkonfigurationen zur Aufschaltung unterschiedlicher elektrischer Fehler.

### Beispiel 1: Wackelkontakt

Die Abbildung der Figur 4 zeigt eine Schalterkonfiguration in einem ersten Beispiel eines aufgeschalteten Fehlers. In diesem ersten Beispiel findet die Fehlersteuereinheit 10 im fünften Schritt 38 eine Fehlerbeschreibung vor, die einen Wackelkontakt auf der ersten elektrischen Leitung 6a beschreibt. Die Fehlerbeschreibung spezifiziert den Wackelkontakt als ein Prellmuster aufeinanderfolgender Zeitintervalle von zufällig variierender Länge, in denen abwechselnd Kontakt und kein Kontakt besteht, deren durchschnittliche Länge fünf Sekunden bei einer Streuung von 4,5 Sekunden beträgt.

Im sechsten Schritt 42 gibt die Fehlersteuereinheit 10 der neuen Fehlerbeschreibung den Namen "Fehler 1" und versendet die neue Fehlerbeschreibung unter diesem Namen an die lokalen Knoten 8.

Der erste lokale Knoten 8a stellt bei der Auswertung der neuen Fehlerbeschreibung im zwölften Schritt 52 fest, dass die erste Schalteranordnung 16a einen regelbaren Halbleiterschalter (siehe Pfeil) umfasst, der für eine Aufschaltung des Fehlerbildes "Wackelkontakt" geeignet ist und über den er den von der ersten elektrischen Leitung 6a geleiteten Strom führen kann. Der erste lokale Knoten 8a vergleicht die Spezifikationen des auf der ersten elektrischen Leitung 6a zu erwartenden Stromes mit den Kennzahlen des identifizierten Halbleiterschalters und stellt fest, dass der Halbleiterschalter die zu erwartende Stromstärke ohne Beschädigung des Halbleiterschalters führen kann und dass die an der ersten elektrischen Leitung 6a zu erwartende Spannung kleiner ist als die Durchschlagsspannung des Halbleiterschalters.

Der erste lokale Knoten 8a erstellt dementsprechend eine neue Ansteuerungsvorschrift mit Anweisungen zur Ansteuerung der ersten Schalteranordnung 16a. Die Anweisungen sind von einer auf der lokalen Prozessoreinheit 18a hinterlegten Ansteuerungsroutine auslesbar und interpretierbar. Die neue Ansteuerungsvorschrift umfasst die Anweisungen, sämtliche Schalter aus der ersten Schalteranordnung 16, mit Ausnahme des identifizierten Halbleiterschalters, zu öffnen bzw. auf nichtleitend zu schalten, eine auf dem ersten lokalen Speicher 20a hinterlegte Prellmuster-Simulationsroutine in die erste lokale Prozessoreinheit 18a zu laden und gemäß den Vorgaben aus der Fehlerbeschreibung zu konfigurieren, und durch Start der Prellmuster-Simulationsroutine den Halbleiterschalter gemäß dem vorgegebenen Prellmuster abwechselnd auf leitend und auf nichtleitend zu schalten.

Der erste lokale Knoten 8a bewertet die Fehlerbeschreibung als ausführbar (zwölfter Schritt 54), versendet ein entsprechendes Bestätigungssignal an die zentrale Fehlersteuereinheit 10 und hinterlegt die Ansteuerungsvorschrift unter dem Namen "Fehler 1" auf dem ersten lokalen Speicher 20.

Im folgenden Verlauf der Simulation versendet die Fehlersteuereinheit 10, sobald eine Triggerbedingung für "Fehler 1" erfüllt ist, einen Ausführungsbefehl "Ausführung Fehler 1" an die lokalen Knoten 8 (achter Schritt 40 und neunter Schritt 46). Der Ausführungsbefehl veranlasst den ersten lokalen Knoten 8a, die unter dem Namen "Fehler 1" hinterlegte Ansteuerungsvorschrift aus dem ersten lokalen Speicher 20a zu laden und mittels der Ansteuerungsroutine auszuführen.

In den nachfolgenden Beispielen werden nur noch die Unterschiede zum Beispiel 1 erläutert. Auf eine ausführliche Beschreibung von Vorgängen, die im Beispiel 1 gleichartig ablaufen, wird verzichtet.

### Beispiel 2: Kriechstrom auf Masse

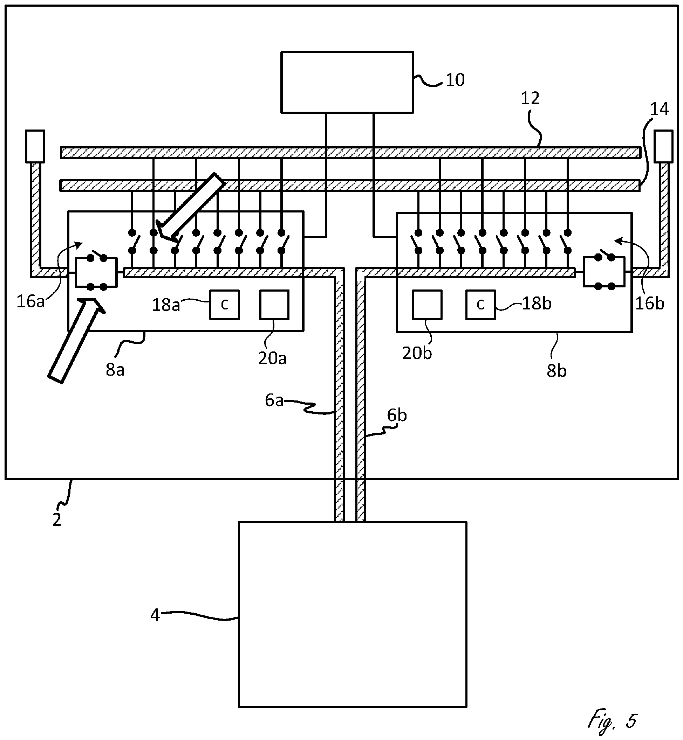

Die Abbildung der Figur 5 zeigt eine Schalterkonfiguration in einem zweiten Beispiel eines aufgeschalteten Fehlers. Die Fehlersteuereinheit 10 findet in diesem Beispiel ein Fehlerszenario vor, das eine Ableitung eines Bruchteils des auf der ersten elektrischen Leitung 6a fließenden Stroms in eine Masse (z.B. eine Fahrzeugkarosserie) infolge eines unerwünschten elektrischen Kontakts (z.B. durch Mantelabrieb) beschreibt. Der elektrische Widerstand des unerwünschten elektrischen Kontakts ist mit 5Ω spezifiziert.

Die Fehlersteuereinheit 10 übersetzt dieses Szenario in eine Fehlerbeschreibung, die eine elektrische Verbindung von der ersten elektrischen Leitung 6a auf die erste Fehlerleitschiene 12 vorgibt, benennt die Fehlerbeschreibung als "Fehler 2" und versendet die Fehlerbeschreibung an die lokalen Knoten 8. Der erste lokale Knoten 8a stellt fest, dass die erste Schalteranordnung 16a einen geeigneten regelbaren Halbleiterschalter umfasst, anhand dessen die erste elektrische Leitung 6a mit dem gewünschten Widerstand mit der ersten Fehlerleitschiene 12 verbindbar ist.

Der erste lokale Knoten 8a erstellt eine neue Ansteuerungsvorschrift. Die neue Ansteuerungsvorschrift enthält die Vorgaben, den besagten Halbleiterschalter auf 5Ω einzustellen, den Hauptstromfluss der ersten elektrischen Leitung 6a widerstandsfrei über einen geschlossenen mechanischen Schalter zu leiten und alle übrigen Schalter aus der ersten Schalteranordnung 16a zu öffnen bzw. auf nichtleitend zu schalten. Der erste lokale Knoten 8a hinterlegt die neue Ansteuerungsvorschrift unter dem Namen "Fehler 2" im ersten lokalen Speicher 20a und wartet auf einen Ausführungsbefehl "Ausführung Fehler 2" zur Ausführung der neuen Ansteuerungsvorschrift.

### Beispiel 3: Kriechstrom zwischen zwei elektrischen Leitungen

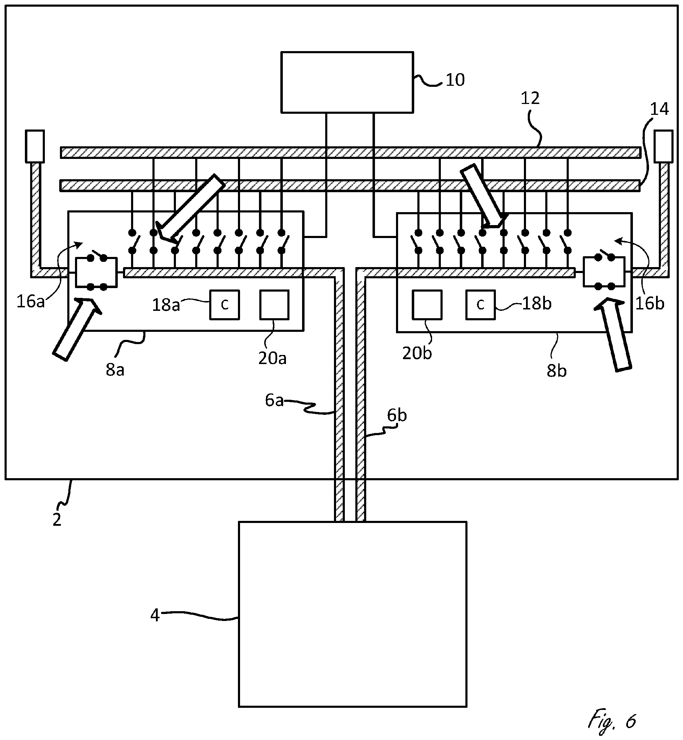

Die Abbildung der Figur 6 zeigt eine Schalterkonfiguration in einem dritten Beispiel eines aufgeschalteten Fehlers. Das Fehlerszenario beschreibt in diesem Beispiel einen Makrofehler, nämlich eine unerwünschte elektrische Verbindung zwischen der ersten elektrischen Leitung 6a und der zweiten elektrischen Leitung 6b. Der elektrische Widerstand der unerwünschten elektrischen Verbindung ist mit 5Ω spezifiziert. Die Fehlersteuereinheit 10 erstellt eine entsprechende Fehlerbeschreibung, benennt sie als "Fehler 3" und versendet sie unter diesem Namen an die lokalen Knoten 8.

Der erste lokale Knoten 8a erkennt bei der Analyse der Fehlerbeschreibung, dass er an der Aufschaltung des Fehlers "Fehler 3" beteiligt ist, weil die Fehlerbeschreibung Vorgaben für die erste elektrische Leitung 6a umfasst. Anhand einer vordefinierten Konvention, die der Routine zur Erstellung einer Ansteuerungsvorschrift bekannt ist, erkennt der erste lokale Knoten 8a außerdem, dass er für die Aufschaltung des in der Fehlerbeschreibung spezifizierten Widerstands verantwortlich ist. Der erste lokale Knoten erstellt daraufhin eine Ansteuerungsvorschrift, um den elektrischen Strom ohne zusätzlichen Widerstand auf der ersten elektrischen Leitung 6a fließen zu lassen und zusätzlich eine elektrische Verbindung zwischen der ersten elektrischen Leitung 6a und der ersten Fehlerleitschiene 12 herzustellen, und hinterlegt die Ansteuerungsvorschrift unter dem Namen "Fehler 3" im ersten lokalen Speicher 20a.

Der zweite lokale Knoten 8b erkennt bei der Analyse der Fehlerbeschreibung, dass er an der Aufschaltung des Fehlers "Fehler 3" beteiligt ist, weil die Fehlerbeschreibung Vorgaben für die zweite elektrische Leitung 6b umfasst. Anhand der vordefinierten Konvention erkennt der zweite lokale Knoten 8b außerdem, dass er für die Aufschaltung des in der Fehlerbeschreibung spezifizierten Widerstands nicht verantwortlich ist. Der zweit lokale Knoten erstellt daraufhin eine Ansteuerungsvorschrift, um den elektrischen Strom ohne zusätzlichen Widerstand auf der ersten elektrischen Leitung 6a fließen zu lassen und zusätzlich eine widerstandsfreie elektrische Verbindung zwischen der zweiten elektrischen Leitung 6b und der ersten Fehlerleitschiene 12 herzustellen, und hinterlegt die Ansteuerungsvorschrift unter dem Namen "Fehler 3" im zweiten lokalen Speicher 20b.

Sobald eine dem "Fehler 3" zugeordnete Triggerbedingung erfüllt ist, versendet die Fehlersteuereinheit 10 einen Ausführungsbefehl "Ausführung Fehler 3" an die lokalen Knoten 8. Der erste lokale Knoten 8a führt daraufhin die Ansteuerungsvorschrift aus, die im ersten lokalen Speicher 20a unter dem Namen "Fehler 3" hinterlegt ist, und der zweite lokale Knoten 8b führt die Ansteuerungsvorschrift aus, die im zweiten lokalen Speicher 20b unter demselben Namen hinterlegt ist. Auf diese Weise ergibt sich gemäß der Vorgabe des Fehlerszenarios eine über die erste Leitschiene 12 geführte elektrische Verbindung der ersten elektrischen Leitung 6a zur zweiten elektrischen Leitung 6b mit einem elektrischen Widerstand in Höhe von 5Ω.

## Patentansprüche

1. Prüfstand (2), eingerichtet zur Konfrontation eines Prüflings (4) mit einem simulierten elektrischen Fehler, umfassend eine zentrale Fehlersteuereinheit (10) zur Orchestrierung der simulierten elektrischen Fehler; und
umfassend zumindest einen ersten lokalen Knoten (8a), eingerichtet zur Ausführung einer von der Fehlersteuereinheit (10) veranlassten Fehlersimulation durch Ansteuerung einer ersten Schalteranordnung (16a) zur Verfälschung ausgewählter elektrischer Ströme im Prüfstand (2);
**dadurch gekennzeichnet, dass** die Fehlersteuereinheit (10) eingerichtet ist, eine erste abstrakte Fehlerbeschreibung, die zumindest einen auf eine erste elektrische Leitung (6a) aufzuschaltenden ersten elektrischen Fehler spezifiziert, zu erstellen und an den ersten lokalen Knoten (8a) zu übermitteln; und
der erste lokale Knoten (8a) eingerichtet ist, aus der ersten abstrakten Fehlerbeschreibung eine zur Aufschaltung des ersten elektrischen Fehlers auf die erste elektrische Leitung (6a) geeignete erste Ansteuerungsvorschrift für die erste Schalteranordnung (16a) herzuleiten
und durch Ansteuerung der ersten Schalteranordnung (16a) gemäß der ersten Ansteuerungsvorschrift den ersten elektrischen Fehler auf die erste elektrische Leitung (6a) aufzuschalten.

2. Prüfstand (2) gemäß Anspruch 1, dessen erster lokaler Knoten (8a) als modulares Bauteil ausgestaltet ist, insbesondere als steckbare Leiterplatte.

3. Prüfstand gemäß Anspruch 1 oder 2, dessen Fehlersteuereinheit (10) eingerichtet ist, zur Orchestrierung der elektrischen Fehler eine auf dem Prüfstand hinterlegte Verkabelungsbeschreibung, in der zumindest die erste elektrische Leitung (6a) aufgeführt ist, auszulesen.

4. Prüfstand (2) gemäß Anspruch 1, dessen Fehlersteuereinheit (10) eingerichtet ist, den ersten elektrischen Fehler in der ersten abstrakten Fehlerbeschreibung als einen Kabelbruch, einen Kurzschluss, einen Kriechstrom auf Masse, einen Kriechstrom zwischen der ersten elektrischen Leitung (6a) und einer zweiten elektrischen Leitung (6b), einen Wackelkontakt oder ein Prellmuster zu spezifizieren.

5. Prüfstand gemäß einem der vorhergehenden Ansprüche, dessen erste elektrische Leitung (6a) eingerichtet ist, einen elektrischen Strom zu leiten, der Energie und/oder Information vom Prüfling (4) zum Prüfstand (2) transferiert oder der Energie und/oder Information vom Prüfstand (2) zum Prüfling (4) transferiert.

6. Prüfstand (2) gemäß einem der vorhergehenden Ansprüche, umfassend eine Anordnung von Fehlerleitschienen (12, 14), wobei der erste lokale Knoten (8a) eingerichtet ist, durch die Ansteuerung der ersten Schalteranordnung (16a) einen elektrischen Kontakt der ersten elektrischen Leitung (6a) zu einer Fehlerleitschiene (12, 14) herzustellen.

7. Prüfstand (2) gemäß Anspruch 6, dessen Anordnung von Fehlerleitschienen (12, 14) parallel verlaufende Fehlerleitschienen (12, 14) mit unterschiedlichen elektrischen Eigenschaften umfasst, wobei insbesondere eine Fehlerleitschiene (12, 14) für die Leitung hoher Stromstärken optimiert ist und eine Fehlerleitschiene (12, 14) für die Leitung elektrischer Signale zur Informationsübertragung optimiert ist.

8. Prüfstand (2) gemäß einem der vorhergehenden Ansprüche, dessen erster lokaler Knoten (8a) eingerichtet ist, die erste Fehlerbeschreibung auf Ausführbarkeit zu prüfen und der Fehlersteuereinheit (10) eine Nichtausführbarkeit der ersten Fehlerbeschreibung zurückzumelden, wobei die Prüfung auf Ausführbarkeit insbesondere zumindest eine der folgenden Prüfungen umfasst:
- einen Vergleich einer Schaltzeit zumindest eines Schalters aus der ersten Schalteranordnung (16a) mit einer in der ersten Fehlerbeschreibung enthaltenen Zeitvorgabe;
- einen Vergleich einer Stromfestigkeit zumindest eines Schalters aus der ersten Schalteranordnung (16a) mit einer in der ersten Fehlerbeschreibung enthaltenen Stromstärkenvorgabe;
- einen Vergleich einer Durchschlagspannung zumindest eines Schalters aus der ersten Schalteranordnung (16a) mit einer in der ersten Fehlerbeschreibung enthaltenen Spannungsvorgabe.

9. Prüfstand (2) gemäß einem der vorhergehenden Ansprüche, dessen Gesamtheit aus Anordnungen von Schaltern (16a), jeweils angesteuert von einem lokalen Knoten (8), mechanische Schalter und Halbleiterschalter umfasst.

10. Prüfstand (2) gemäß einem der vorhergehenden Ansprüche, dessen erster lokaler Knoten (8a) eingerichtet ist, eine zur Aufschaltung des ersten elektrischen Fehlers benötigte erste Zeitspanne zu ermitteln und die erste Zeitspanne der Fehlersteuereinheit (10) zu übermitteln; und
dessen Fehlersteuereinheit (10) eingerichtet ist, die erste Zeitspanne bei der Orchestrierung zu berücksichtigen.

11. Prüfstand (2) gemäß Anspruch 10, umfassend einen zweiten lokalen Knoten (8b), eingerichtet zur Ausführung einer von der Fehlersteuereinheit (10) veranlassen Fehlersimulation durch Ansteuerung einer zweiten Schalteranordnung (16b) zur Verfälschung ausgewählter elektrischer Ströme im Prüfstand (2);
dessen Fehlersteuereinheit (10) eingerichtet ist, eine zweite abstrakte Fehlerbeschreibung, die zumindest einen auf eine zweite elektrische Leitung (6b) aufzuschaltenden zweiten elektrischen Fehler spezifiziert, zu erstellen und an den zweiten lokalen Knoten (8b) zu übermitteln;
wobei der zweite lokale Knoten (8b) eingerichtet ist, aus der zweiten abstrakten Fehlerbeschreibung eine zur Aufschaltung des zweiten elektrischen Fehlers auf die zweite elektrische Leitung (6b) geeignete zweite Ansteuerungsvorschrift für die zweite Schalteranordnung (16b) herzuleiten,
eine zur Aufschaltung des zweiten elektrischen Fehlers benötigte zweite Zeitspanne zu ermitteln und die zweite Zeitspanne der Fehlersteuereinheit (10) zu übermitteln,
und durch Ansteuerung der zweiten Schalteranordnung (16b) gemäß der zweiten Ansteuerungsvorschrift den zweiten elektrischen Fehler auf die zweite elektrische Leitung (6b) aufzuschalten;
wobei die Fehlersteuereinheit (10) eingerichtet ist, die Aufschaltung des ersten elektrischen Fehlers unter Berücksichtigung der ersten Zeitspanne und der zweiten Zeitspanne mit der Aufschaltung des zweiten elektrischen Fehlers zu synchronisieren.
